# EUROPEAN PATENT SPECIFICATION

(11) **EP 1 791 147 B1**
(45) Date of publication and mention of the grant of the patent: **09.02.2011**
(21) Application number: 06256043.8
(22) Date of filing: 24.11.2006
(51) Int. Cl.: H01G 9/20, H01L 51/00

(54) **Electrochemical cell structure and method of fabrication**
Elektrochemische Zellenstruktur und dessen Herstellung
Structure de cellule électrochimique et sa méthode de fabrication

(30) Priority: 25.11.2005 GB 0524068
(43) Date of publication of application: 30.05.2007
(60) Divisional application: 08075525.9
(73) Proprietor: Seiko Epson Corporation, Shinjuku-ku, Tokyo 163-0811 (JP)
(72) Inventor: Shimoda, Tatsuya, Suwa-shi Nagano-ken, 392-8502 (JP); McGregor, Barry M., c/o Cambridge Research, Milton Road Cambridge CB4 0FE (GB); Ishida, Masaya, c/o Cambridge Research, Milton Road Cambridge CB4 0FE (GB)
(74) Representative: Cloughley, Peter Andrew

(56) References cited:
- EP-A- 1 020 881
- EP-A- 1 672 653
- US-A1- 2003 140 959
- US-A1- 2004 252 099

## Description

### FIELD OF THE INVENTION

The present invention relates to an electrochemical cell structure and a method of fabrication.

### BACKGROUND OF THE INVENTION

The International Energy Agency's "World Energy Outlook" predicts that global primary energy demand will increase by 1.7 % per year from 2000 to 2030. It also predicts that 90 % of this demand will be met by fossil fuels. Consequently, there will be a 1.8 % per year increase in carbon dioxide from 2000 to 2030, reaching 38 billion tonnes in 2030. Cleaner, renewable energy sources, including solar cells, have long been heralded as counters to this increased pollution trend. While advanced silicon based solar cells are now widely commercially available, their uptake has been slow due to high production costs, a lack of robustness and associated visual-pollution resulting from the large surface exposure requirements.

Dye Sensitised Solar Cells (DSSC) are an alternative to crystalline solar cells that are cheaper than crystalline solar cells to produce. However, DSSC's are less efficient than crystalline solar cells. Therefore DSSC's require significant area coverage to be effective power generators.

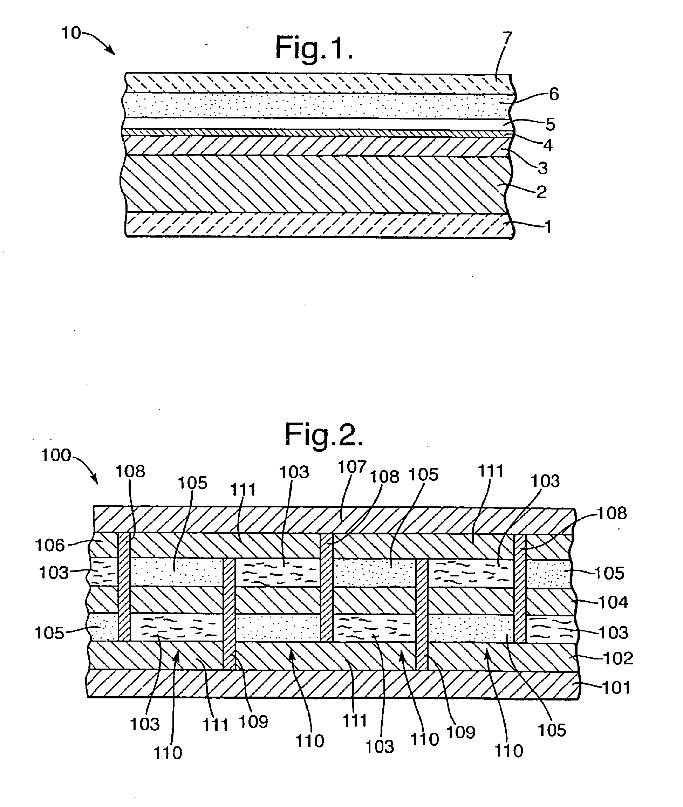

US Patent No. 4,927,721 entitled "Photo-Electrochemical Cell", by M Gratzel et al. discloses a typical DSSC. As illustrated in figure 1, the DSSC 10 comprises a first transparent insulating layer 1; a first transparent conductive oxide (TCO) electrode layer 2; a transparent metal oxide layer 3 of titanium dioxide (TiO₂); a molecular monolayer of sensitiser (dye) 4; an electrolyte layer 5; a second transparent conductive oxide (TCO) electrode layer 6; and a second transparent insulating layer 7.

A DSSC generates charge by the direct absorption of visible light. Since most metal oxides absorb light predominantly in the ultra-violet region of the electromagnetic spectrum, a sensitiser (dye) 4 is absorbed onto the surface of metal oxide layer 3 to extend the light absorption range of the solar cell into the visible light region.

In order to increase the amount of light that the metal oxide layer 3 and the sensitiser (dye) layer 4 can absorb, at least some portion of the metal oxide layer 3 is made porous, increasing the surface area of the metal oxide layer 3. This increased surface area can support an increased quantity of sensitiser (dye) 4 resulting in increased light absorption and improving the energy conversion efficiency of the DSSC to more than 10%.

An electrochromic display (ECD) is a relatively new electrochemical, bi-stable display. While the application is different to the DSSC, these devices share many physical attributes, illustrated in figure 1, exchanging the sensitiser (dye) layer 4 by an electrochromic material layer which undergoes a reversible colour change when an electric current or voltage is applied across the device; being transparent in the oxidised state and coloured in the reduced state.

When a sufficient negative potential is applied to the first transparent conductive oxide (TCO) electrode layer 2, whilst the second transparent conductive electrode oxide (TCO) layer 6 is held at ground potential, electrons are injected into the conduction band of the metal oxide semiconductor layer 3 and reduce the adsorbed molecules (the coloration process). The reverse process occurs when a positive potential is applied to the first transparent conductive oxide (TCO) electrode layer 2 and the molecules become bleached (transparent).

A single electrochromic molecular monolayer on a planar substrate would not absorb sufficient light to provide a strong colour contrast between the bleached and unbleached states. Therefore a highly porous, large surface area, nanocrystalline metal oxide layer 3 is used to promote light absorption in the unbleached state by providing a larger effective surface area for the electrochromophore to bind onto. As light passes through the thick metal oxide layer 3, it crosses several hundreds of monolayers of molecules coloured by the sensitiser (dye) 4, giving strong absorption.

Since the structure of both electrochemical devices is similar, we describe only the method of DSSC manufacture as an example. Equally, this process could be applied with little modification to the ECD manufacture.

In order to manufacture the DSSC 10 illustrated in figure 1, a metal oxide layer 3 of several microns thickness is deposited onto the first transparent conductive oxide (TCO) electrode layer 2, using any one of several techniques, such as screen printing, doctor blading, sputtering or spray coating a high viscosity paste. A typical paste commonly consists of water or organic solvent based metal oxide nanoparticle suspensions (5 - 500 nm diameter), typically titanium dioxide (TiO₂), a viscosity modifying binder, such as polyethylene glycol (PEG), and a surfactant, such as Triton-X. Following deposition the paste is dried, to remove the solvent, and then sintered at temperatures up to 450°C. This high temperature process modifies the metal oxide particle size and density, and ensures the removal of the organic binder constituents, such as polyethylene glycol (PEG) to provide a good conductive path throughout and a well defined material porosity. Sintering also provides good electrical contact between the metal oxide particles and the first transparent conductive oxide (TCO) electrode layer 2.

After drying and cooling, the porous metal oxide layer 3 is coated with sensitiser (dye) 4 by immersion in a low concentration (≤ 1 mM) sensitiser (dye) solution for an extended period, typically 24 hours, to allow absorption of the sensitiser (dye) 4 onto the metal oxide layer 3 through a functional ligand structure, that often comprises a carboxylic acid derivative. Typical solvents used in this process are acetonitrile or ethanol, since aqueous solutions would inhibit the absorption of the sensitiser (dye) 4 onto the surface of the metal oxide layer 3.

The first transparent conductive oxide (TCO) electrode layer 2, having the porous metal oxide layer 3 and sensitiser (dye) layer 4 formed thereon, is then assembled with the second transparent conductive oxide (TCO) electrode layer 6. Both electrode layers 2, 6 are sandwiched together with a perimeter spacer dielectric encapsulant to create an electrode-to-electrode gap of at least 10 µm, before filling with the electrolyte layer 5. The spacer material is most commonly a thermoplastic that provides an encapsulation seal. Once the electrolyte layer 5, which is most commonly an iodide/triiodide salt in organic solvent, is introduced, the DSSC is completed by sealing any remaining aperture with either a thermoplastic gasket, epoxy resin or a UV-curable resin to prevent the ingress of water and hence device degradation.

Most, if not all, of the materials used to fabricate the DSSC can be handled in air and also under atmospheric pressure conditions, removing the necessity for expensive vacuum processes associated with crystalline solar cell fabrication. As a result, a DSSC can be manufactured at a lower cost than a crystalline solar cell.

The ECD fabrication process is very similar to that for the DSSC, with several exceptions. The porous metal oxide layer 3 is often patterned by screen printing to provide a desired electrode image, allowing the device to convey information by colouring or bleaching selected regions. Additionally, the sensitiser (dye) layer 4 is replaced with an absorbed electrochromophore material layer. Furthermore, a permeable diffuse reflector layer, typically large particles of sintered metal oxide, can be positioned between the first and second electrode layers 2, 6 to increase the viewed image contrast.

US Patent No. 5,830,597, entitled "Method and Equipment for Producing a Photochemical Cell", by H Hoffmann also discloses a DSSC 100. As illustrated in figure 2, the DSSC 100 comprises a first substrate 101 of glass or plastic; a first transparent conductive oxide (TCO) layer 102; a titanium dioxide (TiO₂) layer 103, a dye layer 104; an electrolyte layer 105; a second transparent conductive oxide (TCO) layer 106; a second substrate 107 of glass or plastic; and insulating webs 108, 109. The insulating webs 108, 109 are used to form individual cells 110 in the DSSC 100.

An individual cell 110 formed between the insulating web 108 and the insulating web 109 is different from the adjoining individual cell 110 formed between the insulating web 109 and the insulating web 108. This is because the TiO₂ layer 103 and the electrolyte layer 105 are interchanged in each adjoining individual cell 110. Thus, the electrical polarity of the adjoining individual cells 110 is opposite. This alternate division of different layers results in the formation of conducting layers 111 from the electrically conductive layers 102 and 106, each conducting layer 111 connecting a positive (negative) pole of one individual cell 110 to the negative (positive) pole of an adjacent individual cell 110. The resultant structure provides a method of increasing the overall DSSC output voltage, without the necessity of incorporating a multi-layered structure.

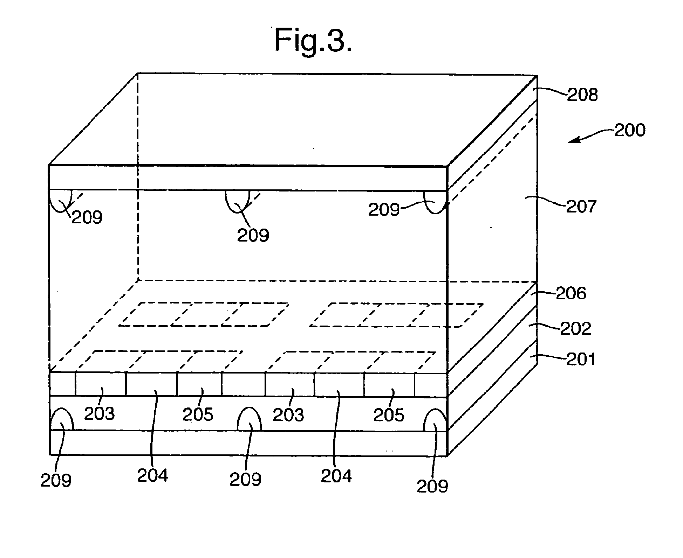

US 2004/0252099 discloses a multi-colour electrochromic display device based on DSSC architecture. US Patent No. 6,310,282B1, entitled "Photovoltaic Conversion Element and a Dye-Sensitising Photovoltaic Cell", by Sakurai et al. discloses a multi-colour DSSC 200. As illustrated in figure 3, the multi-colour DSSC 200 comprises a first transparent electrode layer 201; a transparent semiconductor layer 202 of TiO₂, sensitising dye absorption portions 203, 204, 205, 206, of four colours, absorbed on the surface of the transparent semiconductor layer 202; a carrier transport layer 207; a second transparent electrode layer 208; and auxiliary electrodes 209 attached to the first and second electrode layers 201, 208.

The multi-colour DSSC 200 is manufactured by covering the transparent semiconductor layer 202 with a mask having openings that coincide only with the red sensitising dye absorption portions 203, dipping the transparent semiconductor layer 202 in red sensitising dye for a predetermined period of time, removing the transparent semiconductor layer 202 from the red sensitising dye and removing the mask. Then the transparent semiconductor layer 202 is covered with a mask having openings that coincide only with the green sensitising dye absorption portions 204, the transparent semiconductor layer 202 is dipped in green sensitising dye for a predetermined period of time, the transparent semiconductor layer 202 is removed from the green sensitising dye and the mask is removed. Next the transparent semiconductor layer 202 is covered with a mask having openings that coincide only with the blue sensitising dye absorption portions 205, the transparent semiconductor layer 202 is dipped in blue sensitising dye for a predetermined period of time, the transparent semiconductor layer 202 is removed from the blue sensitising dye and the mask is removed. Finally, the transparent semiconductor layer 202 is dipped in black sensitising dye for a predetermined period of time and the transparent semiconductor layer 202 is removed from the black sensitising dye.

The multi-colour DSSC 200 would have poor picture quality with respect to dye bleeding through the transparent semiconductor layer 202 from the separate dye absorption portions 203, 204, 205, 206 and the lack of greyscale (contrast) control.

In order to improve the incident photon to current conversion efficiency and control the stability/reproducibility of the DSSC performance, it is important to precisely control the physical properties of the metal oxide layer, and hence the absorption of the sensitiser (dye) molecule. However, metal oxide layer fabrication using screen-printing often results in a ± 5 % film thickness variation caused by residual blocked or dirty screen cells, adhesion to the screen during separation from the substrate surface and trapped bubble expansion during drying, caused by the inability to completely outgas a viscous paste. Other methods, such as doctor-blading, also suffer from an inability to provide a well defined thick metal oxide layer without significant spatial deviations. Subsequent porosity and film quality deviations are therefore likely to occur throughout such metal oxide layers, resulting in a degradation of efficiency and image quality for the DSSC and ECD, respectively.

In the case of the ECD, screen-printing demands are further exacerbated by the requirement to create ever finer metal oxide layer features for higher quality images, i.e. increase the dots-per-inch (dpi) for a pixelated display. As the dpi increases, the smallest feature size becomes limited as the screen mesh size approaches the mesh partition width.

As a result, fabrication of an electrochemical device based on a functionally sensitised thick porous metal oxide layer, as for the DSSC and ECD, using the aforementioned fabrication techniques are inappropriate from the view points of device reproducibility and adaptability to large size device production.

### SUMMARY OF THE INVENTION

The present invention aims to address the above mentioned problems of manufacturing electrochemical cells (DSSC's and ECD's) of the prior art, to improve the efficiency with which they are made and thus further decrease the cost of electrochemical cells. Additionally, the present invention aims to produce a multicoloured and/or a grayscale electrochemical cell having improved picture quality with respect to bluring (bleeding) and greyscale (contrast) over that of the prior art.

In a first embodiment of the present invention an electrochemical cell is provided comprising: a first conductive layer; a metal oxide layer formed on the first conductive layer, the metal oxide layer comprising a plurality of adjacent metal oxide cells, spaced from one another; a functional dye layer formed on the metal oxide layer; a second conductive layer; and an electrolyte between the functional dye layer and the second conductive layer, wherein at least one of the first and second conductive layers is transparent; and the functional dye layer comprises at least two different coloured functional dyes each having a depth of colour, such that at least some of the plurality of adjacent metal oxide cells have different colours.

The thickness of the metal oxide layer in at least one metal oxide cell being different in thickness from that of another of the metal oxide cells, such that the depth of colour of the functional dye layer is altered.

In one embodiment at least one of the at least two different coloured functional dyes contributes to the electrochemical cell power generation. In another embodiment the depth of colour of the functional dye layer in at least one metal oxide cell is altered by altering a size of droplets of functional dye formed thereon. In another embodiment the depth of colour of the functional dye layer in at least one metal oxide cell is altered by altering a number of droplets of functional dye formed thereon. In another embodiment the depth of colour of the functional dye layer in at least one metal oxide cell is altered by altering a concentration of functional dye formed thereon.

In a further embodiment the electrochemical cell further comprises: separating means formed on the first conductive layer and surrounding each of the plurality of adjacent metal oxide cells. In another embodiment the separating means is a polymer pattern or a polyimide pattern. In another embodiment at least part of the separating means is hydro- and/or oleophobic and wherein the first conductive layer is hydro- and/or oleophilic.

In a further embodiment the separating means forms a matrix of cells on the first conductive layer. In another embodiment each of the metal oxide cells is substantially square shaped, substantially circular shaped, substantially hexagonal shaped or substantially rectangular shaped. In another embodiment the separating means are banks.

In one embodiment the first conductive layer is transparent, and the electrochemical cell further comprises: a reflector layer provided on the opposite side of the functional dye layer to the at least one transparent conductive layer. In another embodiment the electrochemical cell further comprises: an electrocatalytic layer formed between the electrolyte and the second conductive layer. In another embodiment the electrocatalytic layer is any one of platinum, ruthenium, rhodium, palladium, iridium or osmium.

In a further embodiment the electrochemical cell further comprises: a first insulating substrate on a side of the first conductive layer opposite to the metal oxide layer. In another embodiment the electrochemical cell further comprises: a second insulating substrate on a side of the second conductive layer opposite to the electrolyte. In another embodiment the first insulating substrate is glass or plastic. In another embodiment the metal oxide layer is a titanium dioxide layer. In another embodiment the metal oxide layer comprises particles of metal oxide, and wherein the functional dye layer is formed on a surface of the particles of the metal oxide layer.

In one embodiment the first and second conductive layers are continuous layers. In another embodiment the first conductive layer is a transparent conductive oxide layer. In another embodiment the second conductive layer is a transparent conductive oxide layer. In a further embodiment the electrochemical cell is a dye sensitised solar cell. In another embodiment the electrochemical cell is an electrochromic display. In another embodiment the functional dye layer is an electrochromophore layer.

In another embodiment of the present invention a method of forming an electrochemical cell is provided. The method comprising: forming a first conductive layer; forming a metal oxide layer on the first conductive layer, the metal oxide layer comprising a plurality of adjacent metal oxide cells, spaced from one another; forming a functional dye layer on the metal oxide layer by depositing at least two different coloured functional dyes each having a depth of colour on the metal oxide layer, such that at least some of the adjacent metal oxide cells have different coloured functional dyes; forming a second conductive layer; and providing an electrolyte between the second conductive layer and the functional dye layer, wherein at least one of the first and second conductive layers is transparent.

The thickness of the metal oxide layer in at least one metal oxide cell being different in thickness from that of another of the metal oxide cells, such that the depth of colour of the functional dye layer is altered.

In one embodiment the method further comprises: forming separating means on the first conductive layer surrounding each of the plurality of adjacent metal oxide cells. In another embodiment the metal oxide layer is inkjet printed onto the first conductive layer. In another embodiment the metal oxide layer is inkjet printed onto the first conductive layer in one step. In another embodiment the functional dye is inkjet printed onto the adjacent metal oxide cells of the metal oxide layer.

In one embodiment the method further comprises: providing a reflector layer on the opposite side of the functional dye layer to said at least one transparent conductive layer. In another embodiment the method further comprises: providing an electrocatalytic layer between the electrolyte and the second conductive layer. In another embodiment the method further comprises: forming the first conductive layer on a first insulating substrate, whereby the first insulating substrate and the metal oxide layer are on opposite sides of the first conductive layer. In another embodiment the method further comprises: forming the second conductive layer on a second insulating substrate, whereby the second insulating substrate and the electrolyte are on opposite sides of the first conductive layer.

In another embodiment of the present invention an electrochemical cell structure is provided. The electrochemical cell structure comprises: a plurality of adjacent micro-electrochemical cells, spaced from one another, and wherein the micro-electrochemical cells have different functional dyes, transmissivity, reflectivity or chromaticity from one another. In one embodiment the electrochemical cell structure further comprises: separating means surrounding each of the plurality of adjacent micro-electrochemical cells. In another embodiment the separating means are banks.

In another embodiment of the present invention an electrochemical cell structure is provided. The electrochemical cell structure comprises: a dye sensitised solar cell and an electrochromic display formed on a substrate.

The method of fabrication of the electrochemical cell of the present invention, using inkjet printing, is advantageous over screen printing fabrication as format scaling (up or down) does not require re-investment in machine hardware. This is because inkjet fabrication is software controlled and the software can be reconfigured without the expense of commissioning new screens. Additionally, inkjet heads are significantly more durable, than patterned screens, as patterned screens last only approximately 100 uses.

Furthermore, the drop on demand placement enabled by inkjet fabrication is less wasteful than screen printing. Unlike conventional inkjet overwriting, where each deposited layer is dried and then printed over to produce a thick deposition, the inkjet flood filling technique, which doses a confined region with a large volume of liquid to provide the required deposit thickness, has been shown to produce fracture-free metal oxide layers. Moreover, the surface confinement used to enable flood filling, through the use of a bank structure, ensures long range uniform material distribution and therefore uniform and repeatable performance. Additionally, surface confinement through the use of a bank structure ensures enhanced picture quality and contrast by colour separation between the different coloured cells.

### BRIEF DESCRIPTION OF THE DRAWINGS

Embodiments of the present invention will now be described by way of further example only and with reference to the accompanying drawings, in which:
Figure 1 illustrates a typical Dye Sensitised Solar Cell (DSSC) of the prior art;
Figure 2 illustrates a further DSSC of the prior art;
Figure 3 illustrates a multi-colour DSSC of the prior art;
Figure 4 illustrates an electrochemical cell of a first embodiment of the present invention;
Figure 5 illustrates a process flow diagram for the fabrication of an electrochemical cell of the present invention;
Figure 6 illustrates a simulation of the inkjet liquid profile using (a) a completely hydrophobic bank and (b) a bank with hydrophilic sides;
Figure 7 illustrates the effect of volume conservation when a 30 µm diameter droplet is completely absorbed on a 5 µm thick nanoporous layer;
Figure 8 illustrates an electrochemical cell of a second embodiment of the present invention;
Figure 9 illustrates several pixel cells of a bank structure filled with metal oxide;
Figure 10 illustrates the cross-sectional profiles for the same volume of metal oxide ink deposited in two regions of the same size, one without and one with a bank structure;

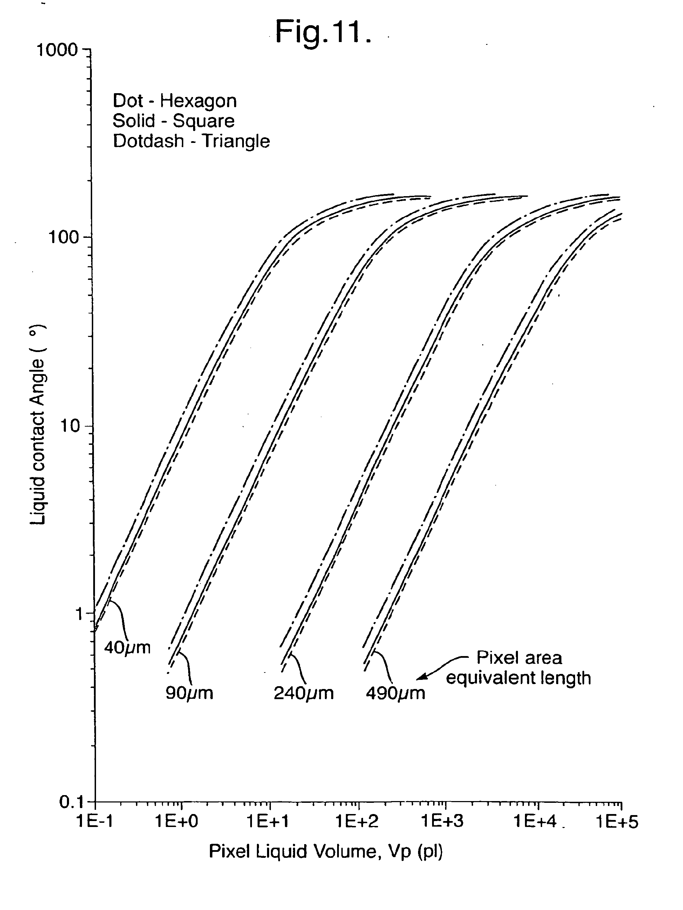

Figure 11 illustrates the maximum contact angle for triangle, square and hexagonal pixel cell shapes; and
Figure 12 illustrates a 200 dpi DSSC cell incorporating an inkjet printed photographic quality image.

### DETAILED DESCRIPTION

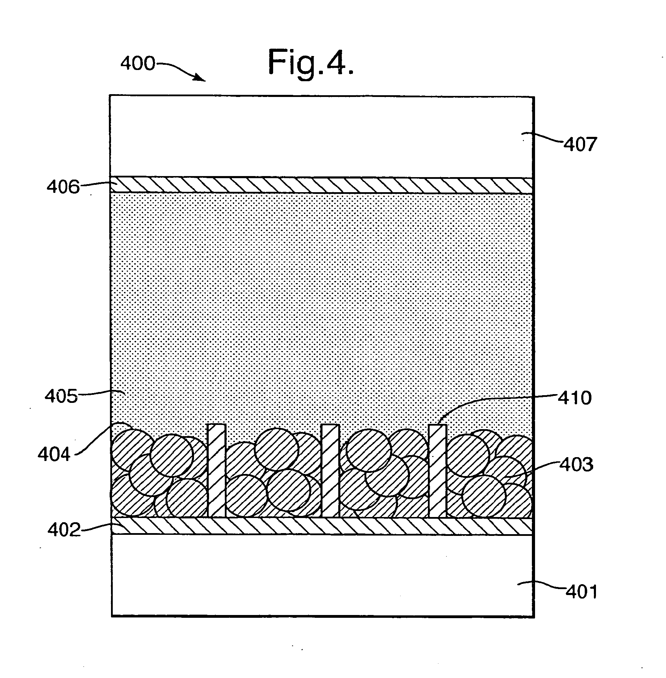

The present invention relates to an electrochemical cell such as a Dye Sensitised Solar Cell (DSSC) or an electrochromic display (ECD). One electrochemical cell 400 of the present invention comprises, with reference to figure 4, a first transparent insulating substrate layer 401; a first transparent conductive oxide (TCO) electrode layer 402; a metal oxide layer 403; a sensitiser (dye)/electrochromic material layer 404; an electrolyte layer 405; a second TCO electrode layer 406; and a second transparent insulating substrate layer 407.

The first and second transparent insulating substrate layers 401, 407 are preferably glass or plastic. The metal oxide layer 403 is preferably titanium dioxide (TiO₂) and is a semiconductor.

The metal oxide layer 403 should preferably be a material which promotes intimate adhesion of the sensitiser (dye)/electrochromic material layer 404 on its surface. Additionally, the particles of the metal oxide layer 403 must be reasonably light transmissible. Particles greater then 500 nm are expected to be opaque and are not generally considered appropriate for use in the present invention. Such large particles would also tend to cause inkjet nozzle blocking.

In a first embodiment of the present invention, a bank structure 410 is formed on the first TCO layer 402, prior to the application of the metal oxide layer 403, so that a metal oxide layer 403 is formed of isolated cells. In one embodiment the bank structure 410 may be formed from a polymer or a polyimide.

Preferably, the bank structure is hydro- and/or oleophobic in some part while the TCO layer 402 is hydro- and/or oleophilic, depending on the nature of the metal oxide ink used to form the metal oxide layer 403.

The bank structure 410 can take on any desired shape forming a matrix of individual pixel cells on the first TCO layer 402, within which the isolated metal oxide cells are formed; such that no metal oxide bridges the bank structure 410 to cause short circuiting.

When the electrochemical cell is an ECD, it is essential that all the metal oxide cells (pixels) are electrically isolated from one another to control the image formation. While the metal oxide cell electrical isolation is not essential when the electrochemical cell is a DSSC, it is preferable to maintain a uniform metal oxide distribution throughout the active device area.

The ECD electrochemical cell can be considered as being composed of a plurality of micro-electrochemical cells, and different micro-electrochemical cells may have different coloured eletrochromophore layers 404. The eletrochromophore layers 404 may also have different transmissivity, reflectivity or chromaticity from one another. Each micro-electrochemical cell is separated from the other micro-electrochemical cells, which together form the ECD, by the bank structure 410. Additionally, an ECD electrochemical cell can be composed of a combination of one or more dye sensitised solar cells and one or more electrochromic display cells formed on a substrate. Each micro-electrochemical cell is preferably between 20 µm to 500 µm across.

In a further embodiment of the present invention an electrocatalytic layer can be formed between the electrolyte layer 405 and the second TCO layer 406. The electrocatalytic layer is preferably greater than 2 nm thick and is selected to enhance the electrolyte regeneration. In the case of the DSSC, effective electrocatalytic metals can be selected from the platinum group metals; platinum, ruthenium, rhodium, palladium, iridium or osmium. The use of an electrocatalytic layer improves the overall performance of the electrochemical cell of the present invention.

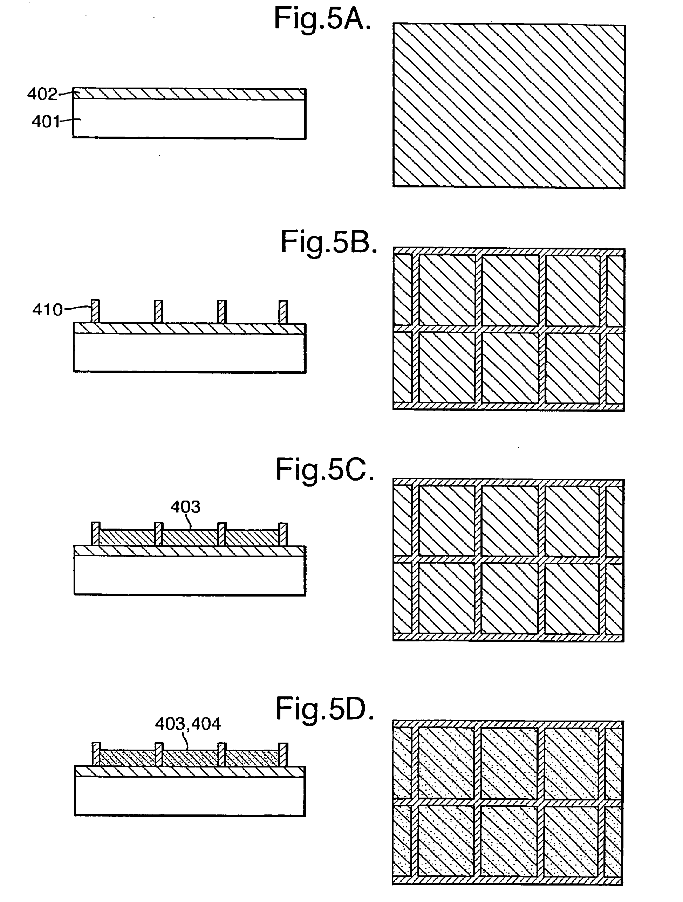

The present invention also relates to a method of fabricating the electrochemical cell 400 of the present invention. Figure 5 illustrates a process flow diagram for the fabrication of the electrochemical cell 400 of the present invention.

The TCO layer 402 is formed on the first transparent insulating substrate layer 401, figure 5a. Preferably, the TCO layer 402 has a sheet resistivity of 8-10 Ω.sq. and is made of indium tin oxide or fluorine doped tin oxide. Fluorine doped tin oxide is preferable due to its cheapness and inertness during the high temperature sintering stage.

The bank structure 410 is then fabricated on the TCO layer 402, figure 5b. In the first embodiment of the present invention, the bank structure 410 forms a matrix of square pixel cells. In order to form the bank structure 410 on the TCO layer 402, a photo-reactive polyimide source material is coated on to the TCO layer 402 and dried. A mask, in the shape of the matrix of pixel cells is then applied to the TCO layer 402. An ultraviolet (UV) light is irradiated through the mask to cause cross-linking of the polyimide in the exposed regions. The unexposed regions are removed by chemical developing, and the bank structure 410 is thermally cured at 350 °C.

The TCO layer 402 having a bank structure 410 is then treated by oxygen or oxygen plus carbon tetrafluoride plasma to remove residual polyimide in the exposed regions. A carbon tetrafluoride (CF₄) plasma treatment is then applied to cause the polyimide bank structure 410 to become hydrophobic, while preserving the hydrophilic nature of the TCO layer 402.

The metal oxide layer 403 is then inkjet printed onto the TCO layer 402 having the bank structure 410 formed thereon. The metal oxide ink is jetted into each of the isolated pixel cells to form the metal oxide layer 403, figure 5c. Preferably, aqueous colloidal titanium dioxide (TiO₂) inks of concentration ≤ 10 % volume fraction (v/v) are used, containing particles < 500 nm in diameter. Other additives can be included in the metal oxide ink to ensure compatibility of the solution with the inkjet head. After deposition, the metal oxide layer 403 is dried and then sintered in air at ≥ 300 °C.

Precise control of the metal oxide layer 403 thickness throughout the device area is essential to provide a uniform canvas on which the DSSC or ECD image can be formed. The thickness of the metal oxide layer 403 is controlled by the concentration of the aqueous colloidal TiO₂ ink, and the deposition volume. The resultant deviation in the peak thickness of the metal oxide layer 403 is less than 1.5 % between pixel cells over a 50 cm² substrate area.

Sensitiser (dye) 404 is then inkjet printed into each of the pixel cells, onto the metal oxide layer 403 formed therein. This method of fabrication allows for the formation of different coloured pixel cells, by enabling the different application of sensitiser(s) (dye(s)) 404 to different pixel cells, in order to create a coloured and/or gray-scale image, with each pixel cell of the bank structure 410 corresponding to a pixel of a picture. Therefore, a high image quality electrochemical cell, with a resolution of 200 dots per inch (dpi) or greater, can be created. The sensitiser (dye) 404 is absorbed by the metal oxide layer 403, figure 5d. After immobilisation of the sensitiser (dye) 404, the excess sensitiser (dye) 404 and remaining solvent is removed by rinsing the complete structure in ethanol and blowing dry in nitrogen.

The first TCO layer 402, having the porous metal oxide layer 403 and sensitiser (dye) layer 404 formed thereon, is then assembled with the second TCO layer 406. Both electrode layers 402, 406 are sandwiched together with a perimeter spacer to create an electrode-to-electrode gap, before filling with the electrolyte layer 405. Once the electrolyte layer 405 is introduced, the DSSC is completed by sealing the remaining aperture.

If an electrocatalytic layer is desired in the electrochemical cell of the present invention, then the electrocatalytic layer is formed on the second TCO layer 406 prior to the electrode layers 402, 406 being sandwiched together.

An inkjet head is capable of providing a well defined aqueous colloidal metal oxide ink droplet, with volume deviation less than ± 1.5 %, to a precise location on the TCO layer 402. Moreover, this volumetric accuracy of ≤ 1.5 % represents that for a commercial printer head. Several industrial heads and complementary techniques are available which can reduce this figure to ≤ 1 %.

Inkjet deposition enables accurate positioning of the metal oxide on the TCO layer 402, within each pixel cell of the bank structure 410 as required. Thus, the thickness of the metal oxide layer 403 can be controlled precisely and a uniform porous metal oxide layer 403 can be obtained. Additionally, inkjet deposition enables accurate positioning of the sensitiser (dye) on the metal oxide layer 403, within each pixel cell of the bank structure 410.

When at least part of the bank structure 410 is hydro- and/or oleophobic, and at least part of the TCO layer 402 is hydro- and/or oleophilic, the bank structure 410 repels the deposited ink, thus correcting the final position of the deposited material on the target surface and compensating for the inherent ± 15 µm droplet lateral divergence from the inkjet nozzle axis. This repulsion is especially beneficial in the case of the ECD to prevent pixel short-circuits caused by printed metal oxide 403 bridging the bank structure 410. The bank structure 410 also enables the formation of a narrower gap between ECD pixels than otherwise permitted by the 30 µm spacing necessary for bankless free-printing, enabling a higher active area ratio to be obtained in the ECD and increased image quality. Furthermore, the bank acts to confine the printed sensitiser ink to a specific device region, preserving the resultant image definition.

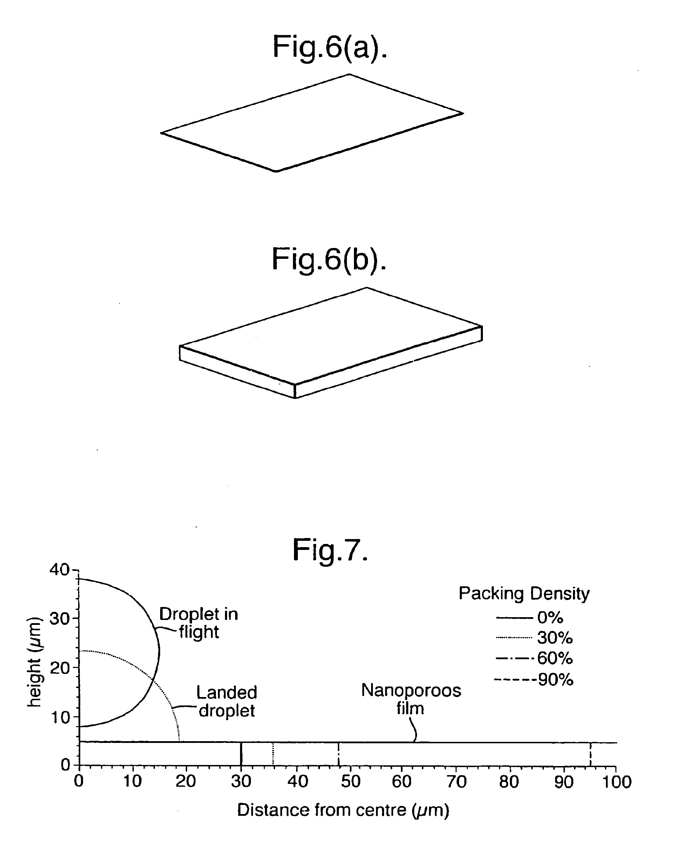

Only a portion of the bank structure 410 needs to be hydro- and/or oleophobic. For example, if the bank wall is hydrophilic and its top hydrophobic, then for an aqueous metal oxide ink the resultant deposit profile will be modified compared to the fully hydrophobic case, as illustrated in figure 6.

Figure 6 illustrates a simulation of the inkjet liquid profile using (a) a completely hydrophobic bank and (b) a bank with hydrophilic sides. The bank structure 410 has been removed from figure 6.

The metal oxide layer 403 should be several microns thick to function effectively. In traditional inkjet printing the thickness of the deposit is built up to the desired profile by using an overwriting technique, wherein each deposited layer is dried and sintered and then overwritten with another layer of ink, and so on, until the desired thickness is reached.

However, the method of the present invention uses a flood filling technique, whereby a large volume of metal oxide ink is introduced into each pixel cell of the bank structure 410 in one pass. The bank structure 410 prevents the metal oxide ink from spreading into neighbouring pixel cells. Using this process, only a single drying and sintering stage is required to produce the desired thickness of the metal oxide layer 403. The bank structure 410 also prevents the sensitiser (dye) 404 from spreading into neighbouring pixel cells, thus preventing colour bleeding, and improving the contrast of any image formed on the electrochemical cell.

The sensitiser (dye) ink solution is absorbed into the porous metal oxide layer 403 through capailary action. If the bank structure 410 was not used to separate the metal oxide layer 403 into isolated pixel cells, then upon jetting from an ink jet head the sensitiser (dye) 404 would spread throughout the metal oxide layer 403 and picture quality would be reduced.

Figure 7 illustrates the effect of volume conservation when a 30 µm diameter droplet, the typical size of an inkjet droplet, is completely absorbed on a 5 µm thick nanoporous layer neglecting capillary and drying effects. As the metal oxide packing density increases, so does the extent of the droplet spreading. Hence, on a continuous nanoporous metal oxide layer 403, the image resolution will be considerably less than that suggested by the droplet size, depending on the film thickness and packing density.

Using a continuous metal oxide layer 403 makes control of image colour depth difficult by inkjet dye overwriting, as the deposited ink merely spreads throughout the porous metal oxide layer 403. To increase the resolution and contrast between the colours and to enable control of sensitiser (dye) 404 colour depth, the metal oxide layer 403 is separated into isolated pixel cells, so that sensitiser (dye) 404 introduced into one cell remains within that cell. Thus, the bank structure 410 is used to prevent lateral liquid diffusion.

Additionally, the use of the bank structure 410 enables the metal oxide layer 403 to have a uniform and repeatable cross-sectional profile throughout, assisting uniformity of colour depth across the image. To provide the required image quality, the pixel cells defined by the bank structure 410 should be as small as practicable.

In the case of the DSSC, not all of the coloured pixel cells are required to be coloured using sensitiser (dye) 404, however, at least some of the colours used in the image should preferably be coloured using sensitiser (dye) 404. The remainder pixel cells of the image can be fabricated using 'inert' dye that contributes to the image but not the electrochemical cell power generation. Though described as 'inert' dyes, they should chemically bond to the metal oxide layer 403 to provide good image stability. If only one coloured sensitiser (dye) 404 is used, black is preferable. This is because black sensitiser (dye) 404 has a high energy conversion efficiency.

However, it is preferable that all the pixel cells are coloured using sensitiser (dye) 404 that contributes to the electrochemical cell power generation to maximise power output. This is because the use of a plurality of isolated pixel cells reduces the energy conversion efficiency of the electrochemical cell of the present invention by area. Additionally, if only some of the pixel cells are coloured using sensitiser (dye) 404 that contributes to the electrochemical cell power generation, then the energy conversion efficiency of the electrochemical cell of the present invention is further reduced.

The depth of colour of the sensitiser (dye) 404 can be controlled through adjustment of the size and number of droplets printed into each pixel cell of the bank structure 410. Additionally, the depth of colour of the sensitiser (dye) 404 can be controlled through adjustment of the thickness of the metal oxide layer 403.

At least four inks are necessary to provide photographic quality images; cyan, magenta, yellow and black or red, green, blue and black depending on the image construction. Many of these coloured sensitisers (dyes) 404 already exist, i.e. Ru^{II}(dmbpy)₂(dcbpy)Cl₂ is a known yellow dye, N719 is a known purple/red dye and Fe^{II} complexes are known blue dyes. To create a colour mix within one pixel cell, a predefined dose of one colour can be jetted into that pixel cell before being overwritten with a different dose of another colour.

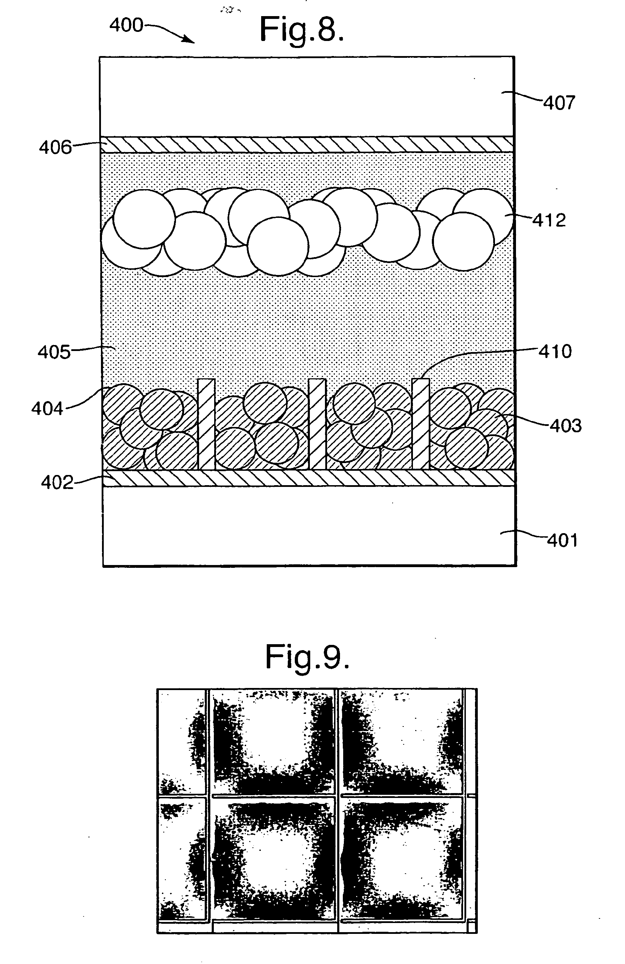

In a further embodiment of the present invention an inert, diffuse, white reflector layer 412 can be provided between the sensitiser (dye) layer 404 and the second TCO layer 406, as illustrated in figure 8, to enhance the electrochemical cell image quality. The white reflector layer 412 provides a clear background against which the image can be viewed. The white reflector layer 412 also causes the light path through the sensitiser (dye) layer 404 to double, increasing the efficiency of the electrochemical cell. The white reflector layer 412 may be formed of large (micron order) TiO₂ particles. It will be clear that the white reflector layer can be provided in other locations to provide this effect. For example, if the second conductor layer and the corresponding substrate are transparent, the reflector layer may be provided behind the substrate or between the substrate and the conductor layer. In addition, although preferred, it is not necessary for the reflector layer to be white - other colours can be used instead, depending on the desired picture.

In another embodiment, only one coloured sensitiser (dye) 404 is used in the electrochemical cell of the present invention. Black is preferred as the colour for the sensitiser (dye) as black sensitiser (dye) has a high energy conversion efficiency. In order to improve the aesthetic appearance of the electrochemical cell, a gray-scale coloured image can be created on the metal oxide layer 403, using only one coloured sensitiser (dye) 404 with each pixel cell of the bank structure 410 corresponding to a pixel of the image.

To create a gray-scale coloured image the depth of "colour" of the sensitiser (dye) 404 in each pixel cell can be controlled through adjustment of the size and number of droplets printed into each pixel cell of the bank structure 410. The greater the number of droplets printed into each pixel cell, the darker that pixel cell appears. The depth of colour of the sensitiser (dye) 404 can be controlled through adjustment of the thickness of the metal oxide layer 403.

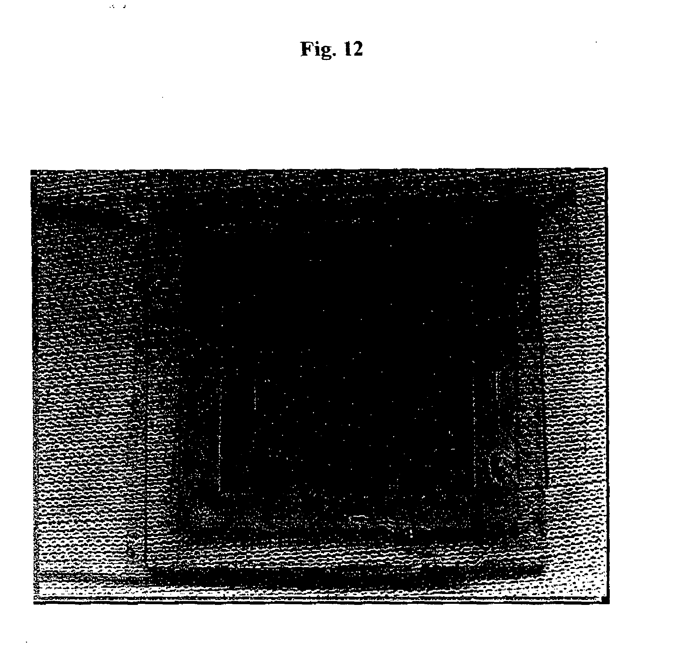

Employing the latter method of creating the image contrast, varying the metal oxide layer 403 thickness by inkjet printing, it is not necessary to inkjet print the sensitizer (dye) 404. Rather the final metal oxide layer 403 film can be simply immersed in a standard sensitiser (dye) 404 solution. The image contrast is then revealed by the capacity of different regions to absorb the sensitiser (dye), as shown in figure 12.

Figure 12, shows a complete DSSC cell created by inkjet printing metal oxide (TiO₂ in this case) onto a 200 dpi polyimide bank patterned ITO coated glass substrate. The thickness of the metal oxide was varied between pixels, which after sintering was immersed in 0.3 mM of N719 ethanolic solution for 24hrs. The electrochemical cell was then completed following the standard method defined previously. The resultant photographic quality monochrome image had 34 levels of gray-scale.

Control of the depth of colour of the sensitiser (dye) 404, within each pixel cell enables the electrochemical cell to comprise a high quality image, with a resolution of 200 dots per inch (dpi) or greater. The image quality of a gray-scale coloured image can be further enhanced by providing an inert, diffuse, white reflector layer 412 between the sensitiser (dye) layer 404 and the second TCO layer 406, as discussed above.

A bank structure 410 having a matrix of square pixel cells produces a pyramidal metal oxide topography as illustrated in figure 9, when the flood filling technique is used to fill each pixel cell with metal oxide ink. The bank structure 410 acts to confine the deposited metal oxide ink to a local region, within the pixel cells of the TCO layer 402. Without this confinement, the metal oxide ink would be distributed freely across the TCO layer 402 following deposition and would form a continuous metal oxide layer 403.

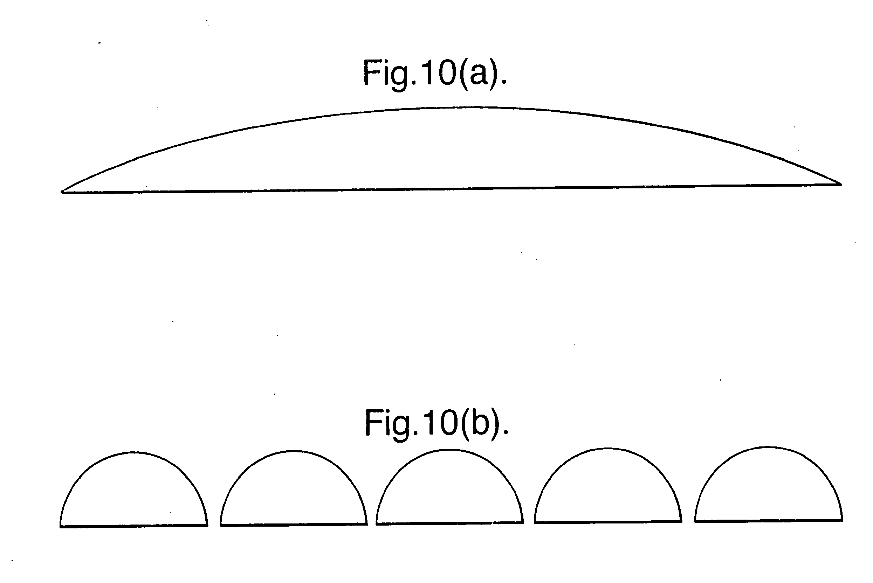

Figure 10 illustrates the cross-sectional profiles for the same volume of metal oxide ink evenly deposited in a region measuring 400 µm x 400 µm. Figure 10a illustrates a TCO layer 402 without a bank structure 410 and figure 10b illustrates a TCO layer 402 having a 2 µm wide bank structure 410 formed at 76 µm intervals. The liquid gradient is much shallower when no bank structure 410 is present, which results in greater metal oxide layer 403 non-uniformity at the edge than in the bank confined case.

The bank structure 410 of the present invention increases the metal oxide layer's 403 ability to accommodate bending stress without fracturing, compared to a continuous metal oxide layer 403. This enables a flexible substrate 401 to be utilised, such as a plastic first insulating substrate 401.

In the first embodiment of the present invention, the bank structure 410 comprises a matrix of square pixel cells as illustrated in figure 9. However, the pixel cells are not limited to being square. When the electrochemical cell 400 of the present invention is an ECD, square pixels are preferred as they are compatible with active matrix backplane fabrication technology. However, when the electrochemical cell 400 of the present invention is a DSSC, several different pixel cell shapes can be used.

It has been determined that the pixel cell shape has little influence on the peak or average metal oxide ink thickness across the TCO layer 402. However, if the volume of the deposited metal oxide ink exceeds the advancing contact angle of the bank material at the bank/ink/air interface, it is likely that the bank structure 410 will be breached and that the metal oxide ink contained in adjacent pixel cells will coalesce. Therefore, a pixel cell shape that minimises the metal oxide ink contact angle at the bank/ink/air interface for a fixed deposition volume is preferable. Additionally, a pixel cell shape that minimises the constriction of the ink on the surface, lowering the minimum surface energy liquid gradient at its periphery is preferable. Figure 8 illustrates the theoretical maximum contact angle for triangle, square and hexagonal pixel cell shapes.

Where the contact angle is less than 90°, the predicted ratios of maximum contact angle are 2.3:1.9:1.0 for the triangle, square and hexagonal pixel cell structures respectively, each having the same unit area. The contact angle is reduced as the number of pixel edges increases. Thus, a circular pixel cell provides the minimal contact angle at the bank/ink/air interface, thereby accepting the most metal oxide ink before breaching the bank structure 410. However, circular pixel cells inhibit the effective device area due to poor tessellation, reducing device performance compared to pixel cells having a higher packing density. While the triangular pixel cell shape has a better active area foot-print, it is disadvantageous due to the large contact angle of constrained inkjet printed metal oxide ink. Therefore, a hexagonal pixel cell shape or a square pixel cell shape is preferable for use in a DSSC of the present invention.

DSSC's of the present invention have been made with an energy conversion efficiency (η), an open circuit voltage (V_{oc}), a short circuit current (I_{sc}) and a fill factor (FF) of 5.0 %, 0.48 V, 15 mA/cm² and 57 %, respectively. The variation in energy conversion efficiency of a electrochemical cell of the present invention over a 50 cm² substrate area is less than 1.5 %. This is due to the process stability of the inkjet fabrication method of the present invention.

Wider bank structures 410 are deleterious to both ECD operation, by a reduction in image quality, and DSSC operation, by a reduction in efficiency; resulting from a decrease in active area. Therefore, the bank structure 410 has a preferable width from 0.2 µm to 20 µm. 0.2 µm is the resolution limit for cost effective fabrication of the bank structure 410 by photolithography. 20 µm is considered the maximum effective bank structure 410 width before serious degradation of the image and performance becomes inhibitive, compared to the lowest common display resolutions of 72 dpi. Using inkjet technology hydrophilic pixel cell sizes less than 1 mm² are readily achievable, though lengths less than several hundred microns are preferred.

In the case of DSSC, absorption of light is proportional to the thickness of the porous metal oxide layer 403. If too thin, a fraction of the incident light will pass unhindered through the metal oxide layer 403, with a loss of potential efficiency. If too thick, once all of the useful light has been completely absorbed, any remaining metal oxide layer 403 thickness will be redundant. Therefore, preferably the thickness of the deposited metal oxide layer 403 should be between from 0.5 µm to 20 µm.

Moreover, due to the uniformity of the thickness of the metal oxide layer 403 produced by inkjet printing over screen printing, the optimal metal oxide layer 403 thickness can be thinner when using inkjet printing.

Furthermore, in the case of screen printing, the ink viscosity must be much higher than that preferred for inkjet printing. Therefore, the material added to increase viscosity must be removed during the sintering process. Consequently, the as-deposited, pre-sintered metal oxide layer 403 thickness must be greater for screen-printing than for inkjet printing.

Although a bank structure 410 is used to form a matrix of isolated pixel cells on the TCO layer 402, prior to application of the metal oxide ink, the present invention is not limited to banks. Any method of forming isolated pixel cells on the TCO layer 402 may be used, such by creating troughs in the TCO layer 402.

Additionally, it is not essential for the first transparent conductive oxide layer 402 to be formed of an oxide material for the electrochemical cell of the present invention to function. Moreover, it is not essential for the second transparent conductive oxide layer 406 to be transparent or formed of an oxide material for the electrochemical cell of the present invention to function. Indeed, it is not essential to provide the second substrate (or either substrate in the finished device).

Any suitable material can be used for the bank structures. However, it is preferred to deposit them as a polymer, and more preferably as a polyimide, pattern.

Although liquid electrolytes have been discussed above, solid or gel electrolytes are also suitable for use in the present invention and, in this context, any reference in this specification to providing an electrolyte between an electrode/conductive layer and another element includes forming the electrode/conductive layer and/or the other element on the electrolyte.

For the avoidance of doubt, the term gray-scale in this specification may refer to different shades or depths of any one or more colours, which may include black. For example, a gray-scale display may comprise different shades of blue; or different shades of red, different shades of green, and different shades of blue.

In summary, the present invention has the advantage of being able to provide a display of one colour, with pixels having different depths of colour; a display of two or more colours, with each pixel of a particular colour having the same depth of colour; and a display of two or more colours, with pixels of a particular colour having different depths of colour.

## Claims

1. An electrochemical cell comprising:
a first conductive layer (402);
a metal oxide layer (403) formed on the first conductive layer (402), the metal oxide layer (403) comprising a plurality of adjacent metal oxide cells, spaced from one another;
a functional dye layer (404) formed on the metal oxide layer (403);
a second conductive layer (406); and
an electrolyte (405) between the functional dye layer (404) and the second conductive layer (406),
wherein at least one of the first and second conductive layers is transparent; and
wherein the functional dye layer (404) comprises at least two different coloured functional dyes each having a depth of colour, such that at least some of the plurality of adjacent metal oxide cells have different colours,
**characterised in that**,
the thickness of the metal oxide layer in at least one metal oxide cell being different in thickness from that of another of the metal oxide cells, such that the depth of colour of the functional dye layer is altered.

2. An electrochemical cell according to claim 1 further comprising:
separating means formed on the first conductive layer and surrounding each of the plurality of adjacent metal oxide cells.

3. An electrochemical cell according to claim 1, wherein at least one of the at least two different coloured functional dyes contributes to the electrochemical cell power generation.

4. An electrochemical cell according to claim 1 or claim 2, wherein the separating means is a polymer pattern.

5. An electrochemical cell according to claim 1 or claim 2, wherein the separating means is a polyimide pattern.

6. An electrochemical cell according to claim 1 or claim 2, wherein at least part of the separating means is hydro- and/or oleophobic and wherein the first conductive layer is hydro- and/or oleophilic.

7. An electrochemical cell according to any one of claims 1 to 6, wherein the separating means forms a matrix of cells on the first conductive layer.

8. An electrochemical cell according to any one of claims 1 to 6, wherein each of the metal oxide cells is substantially square shaped.

9. An electrochemical cell according to any one of claims 1 to 6, wherein each of the metal oxide cells is substantially circular shaped.

10. An electrochemical cell according to any one of claims 1 to 6, wherein each of the metal oxide cells is substantially hexagonal shaped.

11. An electrochemical cell according to any one of claims 1 to 6, wherein each of the metal oxide cells is substantially rectangular shaped.

12. An electrochemical cell according to any one of claims 1 to 11, wherein the separating means arc banks.

13. An electrochemical cell according to any preceding claim, wherein the first conductive layer is transparent, and further comprising:
a reflector layer provided on the opposite side of the functional dye layer to the at least one transparent conductive layer.

14. An electrochemical cell according to any preceding claim, further comprising:
an electrocatalytic layer formed between the electrolyte and the second conductive layer.

15. An electrochemical cell according to claim 14, wherein the electrocatalytic layer is any one of platinum, ruthenium, rhodium, palladium, iridium or osmium.

16. An electrochemical cell according to any preceding claim, further comprising:
a first insulating substrate on a side of the first conductive layer opposite to the metal oxide layer.

17. An electrochemical cell according to claim 16, further comprising:
a second insulating substrate on a side of the second conductive layer opposite to the electrolyte.

18. An electrochemical cell according to claim 16, wherein the first insulating substrate is glass.

19. An electrochemical cell according to claim 16, wherein the first insulating substrates is plastic.

20. An electrochemical cell according to any preceding claim, wherein the metal oxide layer is a titanium dioxide layer.

21. An electrochemical cell according to any preceding claim, wherein the metal oxide layer comprises particles of metal oxide, and wherein the functional dye layer is formed on a surface of the particles of the metal oxide layer.

22. An electrochemical cell according to any preceding claim, wherein the first and second conductive layers are continuous layers.

23. An electrochemical cell according to any preceding claim, wherein the first conductive layer is a transparent conductive oxide layer.

24. An electrochemical cell according to any preceding claim, wherein the second conductive layer is a transparent conductive oxide layer.

25. An electrochemical cell according to any preceding claim, wherein the electrochemical cell is a dye sensitised solar cell.

26. An electrochemical cell according to any one of claims 1 to 25, wherein the electrochemical cell is an electrochromic display.

27. An electrochemical cell according to claim 25, wherein the functional dye layer is an electrochromophore layer.

28. A method of forming an electrochemical cell comprising:
forming a first conductive layer (402);
forming a metal oxide layer (403) on the first conductive layer (402), the metal oxide layer (403) comprising a plurality of adjacent metal oxide cells, spaced from one another;
forming a functional dye layer (404) on the metal oxide layer (403) by depositing at least two different coloured functional dyes each having a depth of colour on the metal oxide layer, such that at least some of the adjacent metal oxide cells have different coloured functional dyes;
forming a second conductive layer (406); and
providing an electrolyte (405) between the second conductive layer (406) and the functional dye layer (404),
wherein at least one of the first and second conductive layers (402, 406) is transparent,
said method being **characterised by**,
the depth of colour of the functional dye layer (404) in at least one metal oxide cell being altered by altering a thickness of the metal oxide layer (403), such that the depth of colour of the functional dye layer is altered.

29. A method of forming an electrochemical cell according to claim 28, wherein the metal oxide layer is inkjet printed onto the first conductive layer.

30. A method of forming an electrochemical cell according to claim 28, wherein the metal oxide layer is inkjet printed onto the first conductive layer in one step.

31. A method of forming an electrochemical cell according to any one of claims 28 to 30, wherein the functional dye is inkjet printed onto the adjacent metal oxide cells of the metal oxide layer.

32. A method of forming an electrochemical cell according to any one of claims 28 to 31, further comprising:
providing a reflector layer on the opposite side of the functional dye layer to said at least one transparent conductive layer.

33. A method of forming an electrochemical cell according to any one of claims 28 to 32, further comprising:
providing an electrocatalytic layer between the electrolyte and the second conductive layer.

34. A method of forming an electrochemical cell according to any one of claims 28 to 33, further comprising;
forming the first conductive layer on a first insulating substrate, whereby the first insulating substrate and the metal oxide layer are on opposite sides of the first conductive layer.

35. A method of forming an electrochemical cell according to claim 34, further comprising:
forming the second conductive layer on a second insulating substrate, whereby the second insulating substrate and the electrolyte are on opposite sides of the first conductive layer.

## Patentansprüche

1. Elektrochemische Zelle, umfassend:
eine erste leitende Schicht (402);
eine Metalloxidschicht (403), die auf der ersten leitenden Schicht (402) gebildet ist, wobei die Metalloxidschicht (403) mehrere benachbarte Metalloxidzellen umfasst, die mit Abstand zueinander angeordnet sind;
eine funktionelle Farbstoffschicht (404), die auf der Metalloxidschicht (403) gebildet ist;
eine zweite leitende Schicht (406); und
einen Elektrolyten (405) zwischen der funktionellen Farbstoffschicht (404) und der zweiten leitenden Schicht (406),
wobei mindestens eine von der ersten und zweiten leitenden Schicht transparent ist; und
wobei die funktionelle Farbstoffschicht (404) mindestens zwei unterschiedlich gefärbte funktionelle Farbstoffe umfasst, die jeweils eine derartige Farbtiefe haben, dass mindestens einige der mehreren benachbarten Metalloxidzellen verschiedene Farben aufweisen,
**dadurch gekennzeichnet, dass**
die Dicke der Metalloxidschicht in mindestens einer Metalloxidzelle eine andere Dicke ist als jene einer anderen der Metalloxidzellen, so dass die Farbtiefe der funktionellen Farbstoffschicht verändert ist.

2. Elektrochemische Zelle nach Anspruch 1, des Weiteren umfassend:
ein Trennmittel, das auf der ersten leitenden Schicht gebildet ist und jede der mehreren Metalloxidzellen umgibt.

3. Elektrochemische Zelle nach Anspruch 1, wobei mindestens einer der mindestens zwei unterschiedlich gefärbten funktionellen Farbstoffe zu der Energieerzeugung der elektrochemischen Zelle beiträgt.

4. Elektrochemische Zelle nach Anspruch 1 oder Anspruch 2, wobei das Trennmittel ein Polymermuster ist.

5. Elektrochemische Zelle nach Anspruch 1 oder Anspruch 2, wobei das Trennmittel ein Polyimidmuster ist.

6. Elektrochemische Zelle nach Anspruch 1 oder Anspruch 2, wobei mindestens ein Teil des Trennmittels hydro- und/oder oleophob ist und wobei die erste leitende Schicht hydro- und/oder oleophil ist.

7. Elektrochemische Zelle nach einem der Ansprüche 1 bis 6, wobei das Trennmittel eine Matrix von Zellen auf der ersten leitenden Schicht bildet.

8. Elektrochemische Zelle nach einem der Ansprüche 1 bis 6, wobei jede der Metalloxidzellen im Wesentlichen quadratisch geformt ist.

9. Elektrochemische Zelle nach einem der Ansprüche 1 bis 6, wobei jede der Metalloxidzellen im Wesentlichen kreisförmig geformt ist.

10. Elektrochemische Zelle nach einem der Ansprüche 1 bis 6, wobei jede der Metalloxidzellen im Wesentlichen hexagonal geformt ist.

11. Elektrochemische Zelle nach einem der Ansprüche 1 bis 6, wobei jede der Metalloxidzellen im Wesentlichen rechteckig geformt ist.

12. Elektrochemische Zelle nach einem der Ansprüche 1 bis 11, wobei die Trennmittel Bänke sind.

13. Elektrochemische Zelle nach einem der vorangehenden Ansprüche, wobei die erste leitende Schicht transparent ist, und des Weiteren umfassend:
eine Reflektorschicht, die auf der gegenüber liegenden Seite der funktionellen Farbstoffschicht zu der mindestens einen transparenten leitenden Schicht bereitgestellt ist.

14. Elektrochemische Zelle nach einem der vorangehenden Ansprüche, des Weiteren umfassend:
eine elektrokatalytische Schicht, die zwischen dem Elektrolyten und der zweiten leitenden Schicht gebildet ist.

15. Elektrochemische Zelle nach Anspruch 14, wobei die elektrokatalytische Schicht eine aus Platin, Ruthenium, Rhodium, Palladium, Iridium oder Osmium ist.

16. Elektrochemische Zelle nach einem der vorangehenden Ansprüche, des Weiteren umfassend:
ein erstes isolierendes Substrat an einer Seite der ersten leitenden Schicht, die der Metalloxidschicht gegenüber liegt.

17. Elektrochemische Zelle nach Anspruch 16, des Weiteren umfassend:
ein zweites isolierendes Substrat an einer Seite der zweiten leitenden Schicht, die dem Elektrolyten gegenüber liegt.

18. Elektrochemische Zelle nach Anspruch 16, wobei das erste isolierende Substrat Glas ist.

19. Elektrochemische Zelle nach Anspruch 16, wobei das erste isolierende Substrat Kunststoff ist.

20. Elektrochemische Zelle nach einem der vorangehenden Ansprüche, wobei die Metalloxidschicht eine Titandioxidschicht ist.

21. Elektrochemische Zelle nach einem der vorangehenden Ansprüche, wobei die Metalloxidschicht Partikel aus Metalloxid umfasst und wobei die funktionelle Farbstoffschicht auf einer Oberfläche der Partikel der Metalloxidschicht gebildet ist.

22. Elektrochemische Zelle nach einem der vorangehenden Ansprüche, wobei die erste und zweite leitende Schicht kontinuierliche Schichten sind.

23. Elektrochemische Zelle nach einem der vorangehenden Ansprüche, wobei die erste leitende Schicht eine transparente leitende Oxidschicht ist.

24. Elektrochemische Zelle nach einem der vorangehenden Ansprüche, wobei die zweite leitende Schicht eine transparente leitende Oxidschicht ist.

25. Elektrochemische Zelle nach einem der vorangehenden Ansprüche, wobei die elektrochemische Zelle eine farbstoffsensibilisierte Solarzelle ist.

26. Elektrochemische Zelle nach einem der Ansprüche 1 bis 25, wobei die elektrochemische Zelle eine elektrochrome Anzeige ist.

27. Elektrochemische Zelle nach Anspruch 25, wobei die funktionelle Farbstoffschicht eine elektrochromophore Schicht ist.

28. Verfahren zum Herstellen einer elektrochemischen Zelle, umfassend:
Bilden einer ersten leitenden Schicht (402);
Bilden einer Metalloxidschicht (403) auf der ersten leitenden Schicht (402), wobei die Metalloxidschicht (403) mehrere benachbarte Metalloxidzellen umfasst, die mit Abstand zueinander angeordnet sind;
Bilden einer funktionellen Farbstoffschicht (404) auf der Metalloxidschicht (403) durch Abscheiden mindestens zwei unterschiedlich gefärbter funktioneller Farbstoffe, die jeweils eine Farbtiefe aufweisen, auf der Metalloxidschicht, so dass mindestens einige der benachbarten Metalloxidzellen unterschiedlich gefärbte funktionelle Farbstoffe aufweisen;
Bilden einer zweiten leitenden Schicht (406); und
Bereitstellen eines Elektrolyten (405) zwischen der zweiten leitenden Schicht (406) und der funktionellen Farbstoffschicht (404),
wobei mindestens eine von der ersten und zweiten leitenden Schicht (402, 406) transparent ist;
wobei das Verfahren **gekennzeichnet ist durch**:
eine Veränderung der Farbtiefe der funktionellen Farbstoffschicht (404) in mindestens einer Metalloxidzelle **durch** Verändern der Dicke der Metalloxidschicht (403), so dass die Farbtiefe der funktionellen Farbstoffschicht verändert ist.

29. Verfahren zum Herstellen einer elektrochemischen Zelle nach Anspruch 28, wobei die Metalloxidschicht auf die erste leitende Schicht tintenstrahlgedruckt wird.

30. Verfahren zum Herstellen einer elektrochemischen Zelle nach Anspruch 28, wobei die Metalloxidschicht auf die erste leitende Schicht in einem Schritt tintenstrahlgedruckt wird.

31. Verfahren zum Herstellen einer elektrochemischen Zelle nach einem der Ansprüche 28 bis 30, wobei der funktionelle Farbstoff auf die benachbarten Metalloxidzellen der Metalloxidschicht tintenstrahlgedruckt wird.

32. Verfahren zum Herstellen einer elektrochemischen Zelle nach einem der Ansprüche 28 bis 31, des Weiteren umfassend:
Bereitstellen einer Reflektorschicht an der gegenüber liegenden Seite der funktionellen Farbstoffschicht zu der mindestens einen transparenten leitenden Schicht.

33. Verfahren zum Herstellen einer elektrochemischen Zelle nach einem der Ansprüche 28 bis 32, des Weiteren umfassend:
Bereitstellen einer elektrokatalytischen Schicht zwischen dem Elektrolyten und der zweiten leitenden Schicht.

34. Verfahren zum Herstellen einer elektrochemischen Zelle nach einem der Ansprüche 28 bis 33, des Weiteren umfassend:
Bilden der ersten leitenden Schicht auf einem ersten isolierenden Substrat, wodurch das erste isolierende Substrat und die Metalloxidschicht an gegenüber liegenden Seiten der ersten leitenden Schicht liegen.

35. Verfahren zum Herstellen einer elektrochemischen Zelle nach Anspruch 34, des Weiteren umfassend:
Bilden der zweiten leitenden Schicht auf einem zweiten isolierenden Substrat, wodurch das zweite isolierende Substrat und der Elektrolyt an gegenüber liegenden Seiten der ersten leitenden Schicht liegen.

## Revendications

1. Cellule électrochimique comprenant :
une première couche conductrice (402) ;
une couche d'oxyde métallique (403) formée sur la première couche conductrice (402), la couche d'oxyde métallique (403) comprenant une pluralité de cellules d'oxyde métallique adjacentes, espacées les unes des autres ;
une couche de colorant fonctionnel (404) formée sur la couche d'oxyde métallique (403) ;
une deuxième couche conductrice (406) ; et
un électrolyte (405) entre la couche de colorant fonctionnel (404) et la deuxième couche conductrice (406),
dans laquelle au moins l'une parmi la première et la deuxième couche conductrice est transparente; et
dans laquelle la couche de colorant fonctionnel (404) comprend au moins deux colorants fonctionnels de couleurs différentes ayant chacun une profondeur de couleur telle, qu'au moins certaines parmi la pluralité des cellules d'oxyde métallique adjacentes ont des couleurs différentes,
**caractérisée en ce que**,
l'épaisseur de la couche d'oxyde métallique dans au moins une cellule d'oxyde métallique est d'une épaisseur différente de celle d'une autre parmi les cellules d'oxyde métallique, de sorte que la profondeur de couleur de la couche de colorant fonctionnel est modifiée.

2. Cellule électrochimique selon la revendication 1, comprenant par ailleurs :
un moyen de séparation formé sur la première couche conductrice et entourant chacune parmi la pluralité des cellules d'oxyde métallique adjacentes.

3. Cellule électrochimique selon la revendication 1, dans laquelle au moins l'un de ces colorants fonctionnels de couleurs différentes, au moins au nombre de deux, contribue à la génération d'énergie de la cellule électrochimique.

4. Cellule électrochimique selon la revendication 1 ou la revendication 2, dans laquelle le moyen de séparation est un motif polymère.

5. Cellule électrochimique selon la revendication 1 ou la revendication 2, dans laquelle le moyen de séparation est un motif polyimide.

6. Cellule électrochimique selon la revendication 1 ou la revendication 2, dans laquelle une partie au moins du moyen de séparation est hydrophobe et/ou oléophobe et dans laquelle la première couche conductrice est hydrophile et/ou oléophile.

7. Cellule électrochimique selon l'une des revendications 1 à 6, dans laquelle le moyen de séparation forme une matrice de cellules sur la première couche conductrice.

8. Cellule électrochimique selon l'une quelconque des revendications 1 à 6, dans laquelle chacune des cellules d'oxyde métallique est essentiellement de forme carrée.

9. Cellule électrochimique selon l'une quelconque des revendications 1 à 6, dans laquelle chacune des cellules d'oxyde métallique est essentiellement de forme circulaire.

10. Cellule électrochimique selon l'une quelconque des revendications 1 à 6, dans laquelle chacune des cellules d'oxyde métallique est essentiellement de forme hexagonale.

11. Cellule électrochimique selon l'une quelconque des revendications 1 à 6, dans laquelle chacune des cellules d'oxyde métallique est essentiellement de forme rectangulaire.

12. Cellule électrochimique selon l'une quelconque des revendications 1 à 11, dans laquelle les moyens de séparation sont des bancs.

13. Cellule électrochimique selon l'une quelconque des revendications précédentes, dans laquelle la première couche conductrice est transparente, et comprenant par ailleurs :
une couche réfléchissante fournie du côté opposé de la couche de colorant fonctionnel par rapport à cette ou ces couches conductrices transparentes.

14. Cellule électrochimique selon l'une quelconque des revendications précédentes, comprenant par ailleurs :
une couche électrocatalytique formée entre l'électrolyte et la deuxième couche conductrice.

15. Cellule électrochimique selon la revendication 14, dans laquelle la couche électrocatalytique est l'un quelconque parmi du platine, du ruthénium, du rhodium, du palladium, de l'iridium ou de l'osmium.

16. Cellule électrochimique selon l'une quelconque des revendications précédentes, comprenant par ailleurs :
un premier substrat isolant d'un côté de la première couche conductrice en opposition à la couche d'oxyde métallique.

17. Cellule électrochimique selon la revendication 16, comprenant par ailleurs :
un deuxième substrat isolant d'un côté de la deuxième couche conductrice en opposition à l'électrolyte.

18. Cellule électrochimique selon la revendication 16, dans laquelle le premier substrat isolant est du verre.

19. Cellule électrochimique selon la revendication 16, dans laquelle le premier substrat isolant est du plastique.

20. Cellule électrochimique selon l'une quelconque des revendications précédentes, dans laquelle la couche d'oxyde métallique est une couche de dioxyde de titane.

21. Cellule électrochimique selon l'une quelconque des revendications précédentes, dans laquelle la couche d'oxyde métallique comprend des particules d'oxyde métallique, et dans laquelle la couche de colorant fonctionnel est formée sur une surface des particules de la couche d'oxyde métallique.

22. Cellule électrochimique selon l'une quelconque des revendications précédentes, dans laquelle les première et deuxième couches conductrices sont des couches continues.

23. Cellule électrochimique selon l'une quelconque des revendications précédentes, dans laquelle la première couche conductrice est une couche d'oxyde conductrice transparente.

24. Cellule électrochimique selon l'une quelconque des revendications précédentes, dans laquelle la deuxième couche conductrice est une couche d'oxyde conductrice transparente.

25. Cellule électrochimique selon l'une quelconque des revendications précédentes, dans laquelle les cellules électrochimiques sont des cellules solaires sensibilisées au colorant.

26. Cellule électrochimique selon l'une quelconque des revendications 1 à 25, dans laquelle la cellule électrochimique est un afficheur électrochromique.

27. Cellule électrochimique selon la revendication 25, dans laquelle la couche de colorant fonctionnel est une couche électrochromophore.

28. Procédé de formation d'une cellule électrochimique comprenant :
la formation d'une première couche conductrice (402) ;
la formation d'une couche d'oxyde métallique (403) sur la première couche conductrice (402), la couche d'oxyde métallique (403) comprenant par ailleurs une pluralité de cellules d'oxyde métallique adjacentes, espacées les unes des autres ;
la formation d'une couche de colorant fonctionnel (404) sur la couche d'oxyde métallique (403) en déposant au moins deux colorants fonctionnels de couleurs différentes ayant chacun une profondeur de couleur sur la couche d'oxyde métallique de manière à ce qu'au moins certaines des cellules d'oxyde métallique aient des colorants fonctionnels de couleurs différentes;
la formation d'une deuxième couche conductrice (406) ; et
la fourniture d'un électrolyte (405) entre la deuxième couche conductrice (406) et la couche de colorant fonctionnel (404),
dans lequel au moins l'une parmi la première et la deuxième couche conductrice (402, 406) est transparente;
ledit procédé **se caractérisant en ce que**,
la profondeur de couleur de la couche de colorant fonctionnel (404) dans au moins une cellule d'oxyde métallique se modifie en modifiant une épaisseur de la couche d'oxyde métallique (403) de manière à ce que la profondeur de couleur de la couche de colorant fonctionnel est modifiée.

29. Procédé de formation d'une cellule électrochimique selon la revendication 28, dans lequel la couche d'oxyde métallique est imprimée par jet d'encre sur la première couche conductrice.

30. Procédé de formation d'une cellule électrochimique selon la revendication 28, dans lequel la couche d'oxyde métallique est imprimée par jet d'encre sur la première couche conductrice en une seule fois.

31. Procédé de formation d'une cellule électrochimique selon l'une quelconque des revendications 28 à 30, dans lequel le colorant fonctionnel est imprimé par jet d'encre sur les cellules d'oxyde métallique adjacentes de la couche d'oxyde métallique.

32. Procédé de formation d'une cellule électrochimique selon l'une quelconque des revendications 28 à 31, comprenant par ailleurs :
la fourniture d'une couche réfléchissante sur le côté opposé de la couche de colorant fonctionnel par rapport à ladite au moins une couche conductrice transparente.

33. Procédé de formation d'une cellule électrochimique selon l'une quelconque des revendications 28 à 32, comprenant par ailleurs :
la fourniture d'une couche électrocatalytique entre l'électrolyte et la deuxième couche conductrice.

34. Procédé de formation d'une cellule électrochimique selon l'une quelconque des revendications 28 à 33, comprenant par ailleurs :
la formation de la première couche conductrice sur un premier substrat isolant, moyennant quoi le premier substrat isolant et la couche d'oxyde métallique se trouvent sur des côté opposés de la première couche conductrice.

35. Procédé de formation d'une cellule électrochimique selon la revendication 34, comprenant par ailleurs :
la formation de la deuxième couche conductrice sur un deuxième substrat isolant, moyennant quoi le deuxième substrat isolant et l'électrolyte se trouvent sur des côtés opposés de la première couche conductrice.
